(19) **Europäisches Patentamt / European Patent Office / Office européen des brevets**

(11) **EP 2 700 131 B1**

(12) **FASCICULE DE BREVET EUROPEEN**

(45) Date de publication et mention de la délivrance du brevet:
**06.09.2017 Bulletin 2017/36**

(21) Numéro de dépôt: **12722435.0**

(22) Date de dépôt: **18.04.2012**

(51) Int Cl.:
*H01S 3/04* *(2006.01)*    *H01S 3/042* *(2006.01)*
*H01S 3/06* *(2006.01)*    *H01S 5/024* *(2006.01)*
*H01S 3/08* *(2006.01)*

(86) Numéro de dépôt international:
**PCT/FR2012/050850**

(87) Numéro de publication internationale:
**WO 2012/172213 (20.12.2012 Gazette 2012/51)**

(54) **DISPOSITIF POUR LA GESTION THERMIQUE D'UN ELEMENT OPTIQUE ET PROCEDE DE GESTION THERMIQUE ASSOCIE**

**VORRICHTUNG ZUR WÄRMEVERWALTUNG BEI EINEM OPTISCHEN ELEMENT UND ZUGEHÖRIGES WÄRMEVERWALTUNGSVERFAHREN**

**DEVICE FOR MANAGING HEAT IN AN OPTICAL ELEMENT, AND RELATED HEAT-MANAGEMENT METHOD**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **18.04.2011 FR 1153358**

(43) Date de publication de la demande:
**26.02.2014 Bulletin 2014/09**

(73) Titulaire: **Ecole Polytechnique**
**91120 Palaiseau (FR)**

(72) Inventeurs:
• **ALBACH, Daniel**
  **F-91120 Palaiseau (FR)**
• **CHANTELOUP, Jean-Christophe**
  **F-91400 Saclay (FR)**
• **LUCIANETTI, Antonio**
  **12000 Prague 2 (CZ)**
• **NOVO, Thierry**
  **F-78470 Saint Remy Les Chevreuse (FR)**
• **VINCENT, Bernard**
  **F-91190 Gif Sur Yvette (FR)**

(74) Mandataire: **Nony**
**11 rue Saint-Georges**
**75009 Paris (FR)**

(56) Documents cités:
**EP-A1- 0 567 287        DE-A1- 3 522 443**
**US-A- 3 679 999        US-A- 5 546 416**
**US-A1- 2007 297 469**

EP 2 700 131 B1

**Description**

**Domaine technique**

La présente invention concerne un dispositif pour la gestion thermique d'un élément optique.

Elle concerne également un procédé de gestion thermique associé audit dispositif, pour gérer la température d'un élément optique.

Le domaine de l'invention est notamment et de manière non limitative celui du refroidissement d'un laser à solide servant à produire un faisceau continu ou des impulsions lumineuses.

**Etat de la technique antérieure**

On connaît dans l'art antérieur un dispositif pour la gestion thermique d'un élément optique comprenant un milieu à gain (élément optique) refroidi par immersion partielle dans un bain d'azote liquide.

Un inconvénient de ce dispositif est qu'il ne présente aucune possibilité d'ajustement en température, celle-ci étant fixée uniquement par la température de l'azote liquide.

On connaît aussi dans l'art antérieur un dispositif pour la gestion thermique d'un élément optique comprenant un milieu à gain en forme plaque (élément optique), fonctionnant en transmission, refroidi des deux côtés par un écoulement d'hélium à haute vélocité, à température ambiante (environ 300 degré Kelvin (K)).

Un inconvénient de ce dispositif est que la pression de jet d'hélium est susceptible de détériorer le milieu à gain ainsi que tout traitement réfléchissant qui serait déposé sur la surface de contact entre le milieu à gain et l'écoulement d'hélium.

Un autre inconvénient de ce dispositif est son instabilité mécanique, les jets de gaz provoquant des vibrations de l'ensemble du dispositif.

Un autre inconvénient de ce dispositif est qu'il nécessite une infrastructure lourde, avec la mise en place notamment d'un réseau de circulation d'hélium à haute pression.

On connaît également dans l'art antérieur un dispositif pour la gestion thermique d'un élément optique, dans lequel une source de froid formée par une plaque de cuivre maintenue à une température voulue est collée contre un milieu à gain pour le refroidir.

Un inconvénient de ce dispositif est que la couche de colle entre le milieu à gain et la source de froid est susceptible d'absorber une fraction de la lumière laser, de s'échauffer en conséquence, puis de détériorer le milieu à gain ainsi que tout traitement réfléchissant qui serait déposé sur la surface de contact entre le milieu à gain et la couche de colle.

Un autre inconvénient de ce dispositif est que la couche de colle entre le milieu à gain et la source de froid peut altérer (via des effets chimiques ou mécaniques) le milieu à gain ainsi que tout traitement réfléchissant qui serait déposé sur la surface de contact entre le milieu à gain et la couche de colle.

Le document EP 0 567 287 A1 décrit un système laser comprenant un cristal laser enfermé dans un boîtier conducteur de chaleur. Le cristal laser est refroidi au moyen de fenêtres optiques conductrices de chaleur disposées de part et d'autre du cristal laser. Les fenêtres optiques peuvent notamment être espacées du cristal laser par des intervalles remplis de gaz.

Le document US 5 546 416 A décrit un système de refroidissement pour un laser en plaques comprenant des couches de conduction thermique séparées de l'élément optique à refroidir par des espaces remplis de gaz.

Le document US 3 679 999 A décrit également une technique de refroidissement d'un laser par interposition d'une fine couche gazeuse entre l'élément laser et des couches solides à haute conductivité thermique.

Un objectif de la présente invention est de proposer un dispositif pour la gestion thermique d'un élément optique, et un procédé de gestion thermique associé, qui ne présentent pas les inconvénients de l'art antérieur.

En particulier, un objectif de la présente invention est de proposer un dispositif pour la gestion thermique d'un élément optique, et un procédé de gestion thermique associé, tels que l'élément optique ainsi qu'un éventuel traitement déposé sur ledit matériau ne soient pas dégradés.

Un autre but de la présente invention est de proposer un dispositif pour la gestion thermique d'un élément optique, et un procédé de gestion thermique associé, permettant un ajustement de la température de l'élément optique.

Un autre but de la présente invention est de proposer un dispositif pour la gestion thermique d'un élément optique, et un procédé de gestion thermique associé, qui soient simples et peu onéreux à mettre en oeuvre.

Un autre but de la présente invention est de proposer un dispositif pour la gestion thermique d'un élément optique, et un procédé de gestion thermique associé, tels qu'on obtienne une grande stabilité mécanique.

Un autre but de la présente invention est de proposer un dispositif pour la gestion thermique d'un élément optique, et un procédé de gestion thermique associé, tels qu'on obtienne une capacité de transfert d'énergie optimale entre l'élément optique et un matériau à une température de référence.

Par « optimal », on entend « permettant d'ajuster la température de l'élément optique à une valeur optimale recherchée »

**Exposé de l'invention**

Cet objectif est atteint avec un dispositif pour la gestion thermique d'un élément optique.
Le dispositif selon l'invention comprend :

- l'élément optique ;
- un matériau à une température de référence ; et
- une couche intermédiaire gazeuse située directement entre le matériau à une température de référence et l'élément optique, ladite couche intermédiaire gazeuse se trouvant sur au moins une partie de son épaisseur dans le régime de diffusion dit « transitoire » défini par une épaisseur de la couche intermédiaire gazeuse telle que le rapport du libre parcours moyen des molécules de gaz dans la couche intermédiaire gazeuse sur ladite épaisseur soit compris entre 0,1 et 10 (inclus), et en ce que l'épaisseur de la couche intermédiaire gazeuse est comprise entre 10 $\mu$m et 5 mm.

Dans la suite, on pourra parler simplement de « régime transitoire ».
On définit un élément optique comme étant tout élément pouvant modifier la direction de propagation, l'amplitude, la phase, la longueur d'onde ou la polarisation d'une onde électromagnétique, ainsi que tout élément pouvant générer une onde électromagnétique.
Cette onde électromagnétique peut avantageusement présenter une longueur d'onde comprise entre $10^{-8}$ m et $10^{-3}$ m.
De préférence, la couche intermédiaire gazeuse se trouve dans le régime de diffusion transitoire au moins à l'interface la plus froide parmi l'interface avec le matériau à une température de référence et l'interface avec l'élément optique.
La couche intermédiaire gazeuse peut se trouver dans le régime de diffusion transitoire à partir de ladite interface la plus froide, sur au moins une partie de son épaisseur en allant vers l'autre interface.
Cette épaisseur peut par exemple être comprise entre 80% et 98% de l'épaisseur totale de la couche intermédiaire gazeuse.
Le régime « transitoire » désigne le régime dans lequel les échanges thermiques dans la couche intermédiaire gazeuse se font préférentiellement via les chocs des molécules du gaz avec les parois du contenant de la couche plutôt que via les chocs des molécules du gaz entre elles.
Ce régime est dit transitoire, puisqu'il est encadré entre :

- un régime dit « moléculaire » dans lequel les échanges thermiques dans la couche intermédiaire gazeuse se font préférentiellement via les chocs des molécules du gaz entre elles ; et
- un régime dans lequel les échanges thermiques dans la couche intermédiaire gazeuse se font quasiment exclusivement (par exemple à plus de 90%) via les chocs des molécules du gaz avec les parois du contenant de la couche gazeuse.

Dans ce régime transitoire, la conductivité thermique de la couche intermédiaire gazeuse dépend en particulier de l'épaisseur de la couche intermédiaire gazeuse, de sa pression et de sa température.
La couche intermédiaire gazeuse est avantageusement en contact direct, et sur toute une surface de contact respective, d'un côté avec le matériau à une température de référence et de l'autre avec l'élément optique.
La conductivité thermique de la couche intermédiaire gazeuse peut définir un flux thermique entre l'élément optique et le matériau à une température de référence, par l'intermédiaire de la couche intermédiaire gazeuse.
On réalise ainsi un dispositif particulièrement adaptable pour la gestion thermique d'un élément optique, puisque la capacité de la couche intermédiaire gazeuse à modifier la température de l'élément optique peut être contrôlée par ces différents paramètres.
On parle de matériau à une température de référence, car c'est la température de ce matériau notamment qui détermine si l'échange thermique avec le milieu optique se fait dans un sens ou dans l'autre.
La couche intermédiaire gazeuse ne nécessite pas de circuit d'écoulement particulier car elle n'a pas pour objet d'évacuer de l'énergie. Son rôle est de transférer l'énergie entre l'élément optique et le matériau à une température de référence.
On réalise ainsi un dispositif particulièrement simple à mettre en oeuvre pour la gestion thermique d'un élément optique.
On réalise ainsi un dispositif mécaniquement stable pour la gestion thermique d'un élément optique.
Le libre parcours moyen d'une molécule représente la distance moyenne que parcourt une particule entre deux collisions.

Le libre parcours moyen A des molécules de gaz peut être défini par la formule suivante :

$$\Lambda = \frac{1}{\sqrt{2}\pi d^2 \left( \dfrac{p}{k_B T} \right)},$$

où

p est la pression en pascal (Pa) ;
Test la température en kelvin (K) ;
$K_B$ est la constante de Boltzmann ;
d est le diamètre des molécules en mètre (m).

On peut définir une épaisseur locale de la couche intermédiaire gazeuse : l'épaisseur de cette couche peut être différente selon les emplacements sur cette couche, tant que l'on reste dans le régime transitoire.

La double inéquation du régime transitoire est vérifiée en particulier pour de faibles valeurs d'épaisseur et de pression de la couche intermédiaire gazeuse.

L'épaisseur de la couche intermédiaire gazeuse peut être comprise plus précisément entre 10 $\mu$m et 1000 $\mu$m.

La pression dans la couche intermédiaire gazeuse peut être comprise entre 1 Pa et $10^5$ Pa.

On peut prévoir que la pression est plus particulièrement comprise entre 500 Pa et 5000 Pa, pour obtenir des propriétés d'adaptabilité améliorées (une faible variation d'un paramètre modifiant alors fortement la conductivité thermique de la couche intermédiaire gazeuse).

La couche intermédiaire est formée par un gaz, et peut être à une pression inférieure à $10^5$ Pa.

On réalise ainsi un dispositif pour la gestion thermique d'un élément optique qui préserve l'intégrité de l'élément optique, ainsi que de tout traitement qui pourrait être déposé sur le dit élément.

L'élément optique peut comprendre au moins un élément parmi :

- un milieu à gain (notamment un milieu à gain classique ou un milieu à gain non linéaire);
- un milieu non linéaire de conversion de fréquence ;
- un milieu multi réfringent (notamment un milieu biréfringent) ;
- un milieu agissant sur la polarisation ;
- un élément dioptrique ;
- un élément catoptrique ; ou
- un milieu semi-conducteur.

On voit donc que l'élément optique peut être notamment une source lumineuse telle qu'une diode électroluminescente ou laser.

Dans tout le texte, un milieu à gain désigne plus particulièrement un milieu à gain optique.

L'élément optique peut être un solide tel qu'un verre, un cristal, une céramique, un semi-conducteur.

L'élément optique peut également être un gaz ou un liquide contenu dans un contenant (par exemple une ampoule de verre).

La largeur spectrale des raies d'émission des milieux à gain solides dépend de la température du milieu à gain solide.

On peut donc obtenir des faisceaux laser dont on contrôle précisément la largeur de la raie émise, dans un système laser incorporant un dispositif selon l'invention et dans lequel l'élément optique est le milieu à gain solide du système laser.

Certains de ces éléments peuvent être le siège d'échauffement, en particulier par absorption partielle de la lumière sur laquelle ils agissent. Par ailleurs, le rendement des sources lumineuses n'étant pas parfait, elles s'échauffent elles aussi.

Le dispositif selon l'invention permet alors de refroidir l'élément optique.

Certains de ces éléments doivent être chauffés pour fonctionner de manière optimale. Cela peut être le cas par exemple pour des milieux non linéaires de conversion de fréquence qui sont chauffés pour satisfaire un accord de phase lié à une acceptance thermique étroite.

Le dispositif selon l'invention permet alors de chauffer l'élément optique.

La couche intermédiaire gazeuse peut être confinée dans un volume fermé.

On évite ainsi le recours à un système compliqué de circulation de gaz.

On peut également assurer une bonne homogénéité de la pression dans toute la couche intermédiaire gazeuse.

Le volume fermé peut être relié à une alimentation en gaz pour compenser d'éventuelles fuites.

En effet, un volume fermé n'est généralement pas totalement hermétique, d'où l'utilité de ladite alimentation en gaz.

On peut également prévoir une faible circulation, allant au-delà de ce qui est nécessaire pour compenser les éventuelles fuites.

La circulation de gaz dans la couche intermédiaire gazeuse est de préférence très faible. Le flux de gaz dans la couche intermédiaire gazeuse est par exemple inférieur à 3% du volume total de la couche intermédiaire gazeuse par seconde.

Selon un mode de réalisation particulièrement avantageux, le matériau à une température de référence présente une température inférieure à 200 K (Kelvin), et l'élément optique est un milieu à gain solide refroidi par le matériau à une température de référence (via la couche intermédiaire gazeuse).

Le milieu à gain solide peut être refroidi à une température inférieure à la température ambiante (300 K) : sa conductivité thermique est plus élevée qu'à température ambiante. On peut ainsi réaliser ainsi dispositif pour une gestion thermique très efficace d'un élément optique.

Dans cette gamme de température, les sections efficaces d'absorption et d'émission d'un élément optique formé par un milieu à gain solide sont élevées.

On peut ainsi augmenter l'efficacité énergétique d'un système laser incorporant un dispositif selon l'invention, où l'élément optique est le milieu à gain solide du système laser.

On peut ainsi réduire l'investissement en termes d'éclairement de pompage optique (source flash, laser, diode, etc....) dans un système laser incorporant un dispositif selon l'invention, où l'élément optique est le milieu à gain solide du système laser.

La couche intermédiaire gazeuse est avantageusement constituée à au moins 90% par de l'Hélium.

L'hélium est un gaz à très forte conductivité thermique

On dispose ainsi d'un bon fluide caloporteur.

En outre, l'hélium est un gaz très léger.

On limite ainsi les perturbations liées à des turbulences dans la couche intermédiaire gazeuse.

On limite ainsi les perturbations sur un faisceau lumineux traversant la couche intermédiaire gazeuse.

La couche intermédiaire gazeuse peut comprendre tout autre gaz, et notamment un mélange de plusieurs gaz.

L'élément optique peut être un milieu à gain qui est agencé pour produire un faisceau laser d'une densité surfacique d'énergie (on peut parler de fluence) au moins égale à 10 J/cm$^2$.

L'émission laser peut être continue ou impulsionnelle.

Dans le cas d'une émission impulsionnelle, les impulsions peuvent par exemple présenter une énergie au moins égale à 10 J.

Le milieu à gain peut être activé par des moyens de pompage optique.

Le milieu à gain peut être placé à l'intérieur d'une cavité résonante à une longueur d'onde d'émission dudit milieu à gain.

Le milieu à gain peut être utilisé comme amplificateur laser simple ou multi passages.

Le dispositif selon l'invention présentant de très bonnes capacités d'évacuation de la chaleur, il est particulièrement adapté au refroidissement d'un milieu à gain utilisé pour produire un faisceau lumineux énergétique.

Selon un mode de réalisation préféré, le dispositif selon l'invention comprend au moins un moyen de réglage parmi :

- un moyen de réglage de l'épaisseur de la couche intermédiaire gazeuse ;
- un moyen de réglage de la pression dans la couche intermédiaire gazeuse;
- un moyen de réglage de la température du matériau à une température de référence.

Ces moyens de réglage forment des moyens d'ajustement et de modification de la température du milieu optique.

On peut en effet modifier la conductivité thermique de la couche intermédiaire gazeuse en modifiant au moins un paramètre parmi :

- l'épaisseur de la couche intermédiaire gazeuse ;
- la pression dans la couche intermédiaire gazeuse ;
- la température du matériau à une température de référence (ce qui permet de modifier la température de la couche intermédiaire gazeuse).

On réalise ainsi un dispositif pour une gestion thermique dynamique. On peut ajuster grâce à au moins un moyen de réglage, la capacité de la couche intermédiaire gazeuse à transférer de l'énergie entre l'élément optique et le matériau à une température déterminée, ce qui définit la température de l'élément optique.

Cette modification peut avoir lieu notamment en cours d'utilisation de l'élément optique, ou entre deux utilisations dans des conditions différentes.

On peut souhaiter par exemple maintenir constante la température du milieu à gain, quelle que soit la puissance moyenne d'émission, dans un système laser incorporant un dispositif selon l'invention, où l'élément optique est le milieu à gain. Dans un système laser en régime impulsionnel, une modification de la puissance moyenne d'émission peut correspondre à une modification de la cadence d'émission d'impulsion ou de l'énergie d'impulsion.

De façon particulièrement avantageuse, le dispositif selon ledit mode de réalisation préféré de l'invention comprend au moins un moyen de réglage pour régler localement l'épaisseur de la couche intermédiaire gazeuse, la pression dans la couche intermédiaire gazeuse et/ou la température du matériau à une température de référence.

Par localement on entend que le réglage peut être différent selon la localisation dans le plan défini par la couche intermédiaire gazeuse.

On réalise ainsi un dispositif pour une gestion thermique dynamique, et capable de s'adapter à des inhomogénéités locales des conditions d'utilisation dudit dispositif.

Le dispositif selon ledit mode de réalisation préféré de l'invention peut comprendre des moyens de contre-réaction agissant sur au moins un moyen de réglage en fonction d'au moins une mesure représentative de la température de l'élément optique.

La mesure représentative de la température de l'élément optique peut être une mesure directe : mesure de la température, par exemple en surface de l'élément optique.

La mesure représentative de la température de l'élément optique peut être une mesure indirecte, notamment une mesure de :

- la distribution de phase d'une onde lumineuse dite « sonde » traversant ou se réfléchissant sur l'élément optique, et dont on connaît la distribution de phase avant d'avoir atteint l'élément optique ;
- la distribution de phase d'une onde lumineuse émise par l'élément optique ;
- la distribution de phase d'une onde lumineuse dont la direction de propagation, l'amplitude, la phase, la longueur d'onde ou la polarisation est modifiée par l'élément optique ;
- la distribution de gain si l'élément optique est un milieu à gain
- la déformation physique de l'élément optique (en utilisant par exemple des éléments palpeurs).

On peut ainsi réaliser un asservissement, de préférence en temps réel, de la température de l'élément optique, de façon positionner celle-ci à tout moment à une valeur voulue.

Selon ledit mode de réalisation préféré de l'invention, le dispositif selon l'invention comprend des moyens de modification d'une cadence d'utilisation de l'élément optique.

La cadence d'utilisation peut être comprise entre une utilisation en continu, et une utilisation pour obtenir une impulsion unique (monocoup).

Plus particulièrement, la cadence d'utilisation peut être comprise entre 1 Hz et 10 Hz.

Une modification de la cadence d'utilisation de l'élément optique entraîne une modification de sa température. Cette modification peut être compensée grâce à au moins un moyen de réglage.

De façon avantageuse, l'élément optique présente une face recouverte d'un traitement hautement réfléchissant (par exemple une réflectivité supérieure à 99,5% à la longueur d'onde de l'onde réfléchie) et la couche intermédiaire gazeuse est en contact direct avec ladite face.

On considère alors que le traitement hautement réfléchissant fait partie de l'élément optique.

Un tel agencement peut correspondre aux lasers à disque, encore appelés « miroir actifs », la couche intermédiaire gazeuse étant située du côté du traitement réfléchissant aux longueurs d'onde laser de pompage et d'émission, pour ne pas perturber les faisceaux lumineux associés pénétrant et sortant de l'élément optique constitué par le milieu à gain.

On réalise ainsi un refroidissement présentant les avantages précités, tel que le traitement hautement réfléchissant ne soit soumis à aucune contrainte destructrice.

L'invention concerne également un procédé de gestion thermique, pour la gestion thermique d'un élément optique, mis en oeuvre dans un dispositif selon l'invention.

Selon ce procédé, on utilise une couche intermédiaire gazeuse située directement entre un matériau à une température de référence et l'élément optique, ladite couche intermédiaire gazeuse se trouvant sur au moins une partie de son épaisseur dans le régime de diffusion dit « transitoire » défini par une épaisseur de la couche intermédiaire gazeuse telle que le rapport du libre parcours moyen des molécules de gaz dans la couche intermédiaire gazeuse sur ladite épaisseur soit compris entre 0,1 et 10 (inclus), et en ce que l'épaisseur de la couche intermédiaire gazeuse est comprise entre 10 $\mu$m et 5 mm. Les effets techniques et avantages évoqués à propos du dispositif selon l'invention se retrouvent dans le procédé selon l'invention.

On peut choisir le rapport du libre parcours moyen des molécules de gaz dans la couche intermédiaire gazeuse, sur l'épaisseur de la couche intermédiaire gazeuse, compris entre 0,1 et 10 (inclus).

De façon avantageuse, on règle au moins un paramètre parmi :

- la pression dans la couche intermédiaire gazeuse ;
- l'épaisseur de la couche intermédiaire gazeuse ;
- la température du matériau à une température de référence ;

de façon à asservir la température de l'élément optique.

Ce réglage peut être local, c'est-à-dire fonction de la localisation dans le plan défini par la couche intermédiaire gazeuse.

On peut mettre en oeuvre une contre-réaction pour agir sur au moins un paramètre de réglage en fonction d'au moins une mesure représentative de la température de l'élément optique.

De préférence, on règle au moins un paramètre parmi :

- la pression dans la couche intermédiaire gazeuse ;
- l'épaisseur de la couche intermédiaire gazeuse ;
- la température du matériau à une température de référence ;

en fonction d'une cadence d'utilisation de l'élément optique.

Ainsi, on peut notamment maintenir constante une température de l'élément optique, quelle que soit sa cadence d'utilisation.

On peut utiliser le procédé selon l'invention pour mettre en oeuvre un transfert thermique compris entre 1 mW/cm$^2$ et 50 W/cm$^2$, entre l'élément optique et le matériau à une température de référence, par l'intermédiaire de la couche intermédiaire gazeuse.

En particulier, on peut utiliser le procédé selon l'invention pour mettre en oeuvre un transfert thermique compris entre 1 W/cm$^2$ et 10 W/cm$^2$, entre l'élément optique et le matériau à une température de référence, par l'intermédiaire de la couche intermédiaire gazeuse.

L'élément optique peut par exemple être un milieu à gain agencé pour produire un faisceau laser et nécessitant l'évacuation d'un flux de chaleur défini par une densité de puissance comprise entre 1 W/cm$^2$ et 10 W/cm$^2$.

**Description des figures et modes de réalisation**

D'autres avantages et particularités de l'invention apparaîtront à la lecture de la description détaillée de mises en oeuvre et de modes de réalisation nullement limitatifs, et des dessins annexés suivants :

- la figure 1 illustre de façon schématique un dispositif selon l'invention ;
- la figure 2 illustre un premier mode de réalisation de dispositif selon l'invention ;
- la figure 3A illustre un graphique de conductivités thermiques en fonction de la pression, dans une couche intermédiaire gazeuse d'un dispositif selon l'invention, et pour différentes épaisseurs et températures de ladite couche ;
- la figure 3B illustre un graphique de conductivités thermiques en fonction de la température, dans une couche intermédiaire gazeuse d'un dispositif selon l'invention, et pour différentes épaisseurs de ladite couche ;
- la figure 4 illustre un graphique de températures de l'élément optique, en fonction de la pression dans la couche intermédiaire gazeuse dans un dispositif selon l'invention et pour différentes épaisseurs de celle-ci ;
- la figure 5A illustre un graphique de transferts thermiques en fonction de la pression, dans une couche intermédiaire gazeuse d'un dispositif selon l'invention, et pour différentes épaisseurs de ladite couche ;
- la figure 5B illustre un graphique de transferts thermiques en fonction de la pression, dans une couche intermédiaire gazeuse d'un dispositif selon l'invention, pour différentes épaisseurs de ladite couche et pour deux températures du matériau à une température de référence ;
- la figure 6 illustre un deuxième mode de réalisation de dispositif selon l'invention ;
- la figure 7 illustre un troisième mode de réalisation de dispositif selon l'invention ; et
- la figure 8 illustre l'utilisation d'un quatrième mode de réalisation de dispositif selon l'invention.

La description du dispositif selon l'invention servira également à illustrer le procédé selon l'invention.

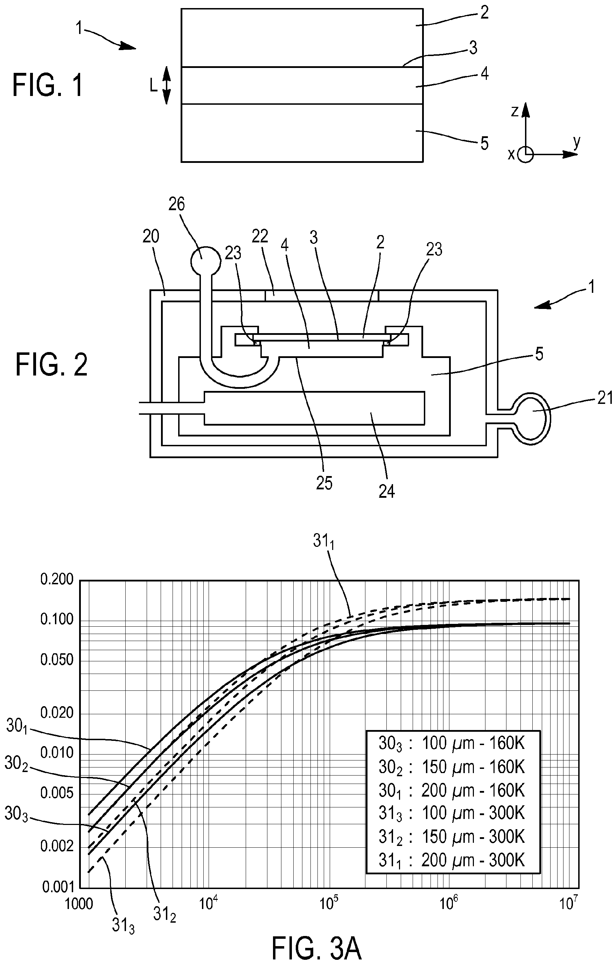

On va tout d'abord décrire, en référence à la figure 1 et de façon schématique, le dispositif 1 selon l'invention.

Le dispositif 1 selon l'invention comprend un élément optique 2 dont on souhaite pouvoir piloter la température.

L'élément optique 2 peut être formé par :

- un milieu non linéaire de conversion de fréquence tel qu'un cristal de D-KDP (Phosphate de Potassium Dihydrogéné Deutéré) ou un cristal de Niobate de Lithium, pouvant être utilisé dans un dispositif de doublage de fréquence ou de somme de fréquence par exemple ;
- un milieu à gain « classique » pouvant être utilisé dans une cavité ou un amplificateur laser, tel qu'un cristal de YAG (Yttrium Aluminium Garnet) dopé Yb (Ytterbium) ou son équivalent céramique obtenu par exemple par frittage, un verre dopé, un cristal de $CaF_2$ (fluorite) dopé, etc ;
- un milieu à gain non linéaire tel que le BBO (Béta Borate de Baryum), pouvant former :

  ○ avec une cavité résonante un oscillateur paramétrique optique (OPO) ;
  ○ un amplificateur paramétrique optique (OPA)
  ○ un amplificateur paramétrique optique pour impulsion étirée (OPCPA)

- un milieu agissant sur la polarisation tel qu'un cristal de Niobate de Lithium pouvant être utilisé dans une cellule de Pockels ;
- un milieu multi réfringent tel qu'un cristal de TGG (Terbium Gallium Garnet) pouvant être utilisé dans un rotateur de Faraday ;
- un élément dioptrique tel qu'une lentille optique ou un hublot ;
- un élément catadioptrique tel qu'un miroir optique ;
- un élément semi-conducteur tel qu'une diode électroluminescente ou une diode laser ;
- etc.

L'élément optique 2 est en contact direct, sur une surface de contact 3, avec une couche intermédiaire gazeuse 4.

La surface de contact 3 telle que représentée est plane, mais ce n'est pas le cas général. On peut envisager toute forme.

La couche intermédiaire peut être formée par un gaz tel que l'hélium, qui présente l'avantage d'offrir une très bonne conductivité thermique et d'être un gaz léger formant peu de turbulences atmosphériques susceptibles de perturber un faisceau lumineux traversant la couche intermédiaire gazeuse 4 mais aussi.

La couche intermédiaire gazeuse 4 peut également être formée par tout autre gaz ou mélange de plusieurs gaz (azote, l'air, etc).

La couche intermédiaire gazeuse 4 est en contact d'un côté avec l'élément optique 2, et de l'autre avec le matériau 5 à une température de référence.

Le matériau 5 à une température de référence peut être formé par un métal tel que du cuivre, ou par un cristal tel qu'un diamant ou un saphir (en particulier dans le cas où l'on travaille en transmission, c'est-à-dire lorsqu'on souhaite utiliser un faisceau lumineux après traversée de l'élément optique 2 puis de la couche intermédiaire gazeuse 4).

Le matériau 5 à une température de référence peut également être liquide ou même un gaz.

La couche intermédiaire gazeuse 4 se trouve dans un régime transitoire dans lequel les échanges thermiques se font préférentiellement via les chocs moléculaires avec les parois de la couche intermédiaire gazeuse 4.

Pour que les conditions de régime transitoire soient réunies il faut que la probabilité de rencontrer une paroi soit plus élevée que celle de rencontrer une autre molécule.

Pour chaque épaisseur de la couche intermédiaire gazeuse 4, à une température donnée et pour une composition gazeuse donnée, il existe une pression maximum à ne pas dépasser.

Les conditions de température, de pression et d'épaisseur sont réunies, pour la composition gazeuse de la couche intermédiaire gazeuse, de sorte dans au moins 90% de l'épaisseur de la couche intermédiaire gazeuse 4, le rapport du libre parcours moyen des molécules de gaz, sur l'épaisseur de ladite couche, soit compris entre 0,1 et 10.

La couche intermédiaire gazeuse peut être située dans le régime transitoire dans lequel ce rapport est compris entre 0,1 et 10, excepté sur une très fine lamelle, à l'interface avec un matériau très chaud comme par exemple l'élément optique 2.

La couche intermédiaire gazeuse 4 peut présenter une épaisseur comprise entre 10 $\mu$m et 5 mm.

La couche intermédiaire gazeuse 4 peut présenter une pression de gaz comprise entre 1 Pa et $10^5$ Pa.

Dans ce régime transitoire, la conductivité thermique du gaz formant la couche intermédiaire gazeuse 4 dépend alors de la température, la pression et la géométrie du volume contenant cette couche, selon la formule suivante :

$$k(T) = f(T, L, p) = k_{bulk}(T) . \left( 1 + \frac{8}{3} . \frac{\alpha \, k_{bulk}(T).T}{L.p.\sqrt{3.R.T}} . \right)^{-1} ,$$

où

k(T) est la conductivité thermique de la couche intermédiaire gazeuse 4 à la pression p et à la température $T$ ;

$k_{bulk}(T)$ est la conductivité thermique de la couche intermédiaire gazeuse 4 à pression atmosphérique et à la température $T$ ;

$T$ est la température en K (Kelvin) dans la couche intermédiaire gazeuse 4 (liée à la température du matériau 5 à une température de référence) ;

$p$ est la pression en Pa (Pascal) dans la couche intermédiaire gazeuse 4 ;

$R$ est une constante du gaz formant la couche intermédiaire gazeuse 4 ;

$L$ est l'épaisseur de la couche intermédiaire gazeuse 4 ;

$\alpha$ est un facteur d'ajustement thermique lié à la nature du gaz utilisé (mono, di-atomique,...) et aux interactions entre ce gaz et les matériaux constituants l'élément optique et le matériau à une température de référence, que l'on fixera à 4 pour les cas physiques les graphiques représentés aux figures 3A, 3B, 4, 5A et 5B.

Le dispositif 1 selon l'invention est donc adaptable : en fonction d'une quantité d'énergie que l'on souhaite transférer entre l'élément optique 2 et le matériau 5, par l'intermédiaire de la couche intermédiaire gazeuse 4, et pour une composition donnée du gaz dans la couche intermédiaire gazeuse 4, on fixe les trois paramètre $p, L,$ et $T$ pour la couche intermédiaire gazeuse 4.

On peut par exemple souhaiter conserver la température de l'élément optique 2 et pour cela :

- fixer $L$ et la température du matériau 5, et ajuster p, ou
- fixer $p$ et la température du matériau 5, et ajuster L, ou
- fixer $p$ et $L,$ et ajuster la température du matériau 5.

Chacun des paramètres peut être exprimé en fonction de coordonnées x et y correspondant à une position sur la surface de la couche intermédiaire gazeuse 4 (par opposition à la position dans la dimension z de l'épaisseur de la couche intermédiaire gazeuse 4).

On va maintenant décrire, en référence à la figure 2, un premier mode de réalisation du dispositif 1 selon l'invention.

Selon ce mode de réalisation, le dispositif 1 selon l'invention est placé dans une enceinte 20 sous vide grâce à la pompe à vide 21. On évite ainsi en particulier toute condensation sur la face de l'élément optique 2, du côté opposé à la couche intermédiaire gazeuse 4.

Cette enceinte 20 n'est requise que dans le cas où l'on souhaite amener l'élément optique 2 à une température inférieure au point de rosée de l'environnement.

Une fenêtre à vide 22 permet de laisser passer à l'intérieur de l'enceinte 20 un faisceau lumineux, par exemple un faisceau de pompe lorsque l'élément optique 2 est formé par un milieu à gain.

Dans l'exemple représenté à la figure 2, l'élément optique 2 travaille en réflexion, tous les faisceaux lumineux passant par la fenêtre à vide 22.

L'épaisseur de la couche intermédiaire gazeuse 4 est déterminée par la hauteur des cales 23 (par exemple des cales en téflon ou polyimide).

La couche intermédiaire gazeuse 4 est formée par de l'hélium et elle est reliée à une alimentation en hélium 26 de façon à compenser les pertes dans le volume fermé 25 formé entre l'élément optique 2, matériau 5 à une température de référence, et les cales 23.

Le matériau 5 à une température de référence est formée par du cuivre métal maintenu à 77 K par une enceinte d'azote liquide 24 reliée à une boucle de refroidissement (non représentée).

On peut ainsi obtenir des températures de l'ordre de 160 K dans l'élément optique 2.

Un intérêt de ces basses températures se présente en particulier lorsque l'élément optique 2 est un milieu à gain solide.

La conductivité thermique de certains solides tels que des milieux à gain est d'autant plus élevée que leur température est basse. Le dispositif 1 selon l'invention est alors particulièrement efficace pour refroidir l'élément optique 2.

A ces températures, les sections efficaces d'absorption et d'émission des milieux à gain sont augmentées. On augmente ainsi l'efficacité énergétique d'un laser et on peut réduire par exemple d'un facteur trois un investissement en éclairement de pompage, par exemple en diode de pompe.

Les raies d'émission des milieux à gain sont d'autant plus fines que la température est basse, et leur largeur dépend de la température du milieu à gain : on peut contrôler précisément la largeur spectrale de la longueur d'onde d'émission laser.

On peut également utiliser une enceinte d'hélium liquide plutôt que d'azote liquide, ou tout autre milieu réfrigérant, par exemple de l'eau à 280 K si l'on ne souhaite pas refroidir à des températures cryogéniques.

Les conditions de température, de pression et d'épaisseur sont réunies de sorte que le rapport du libre parcours moyen des molécules de gaz et de l'épaisseur de ladite couche, dans au moins 95% de l'épaisseur de la couche intermédiaire gazeuse 4, soit compris entre 0,1 et 10.

On va ensuite s'intéresser de plus près à l'étude de la conductivité thermique du gaz formant la couche intermédiaire gazeuse 4.

La température dans la couche intermédiaire gazeuse peut présenter un gradient, depuis l'interface avec le matériau 5 à une température de référence jusqu'à l'interface avec l'élément optique 2.

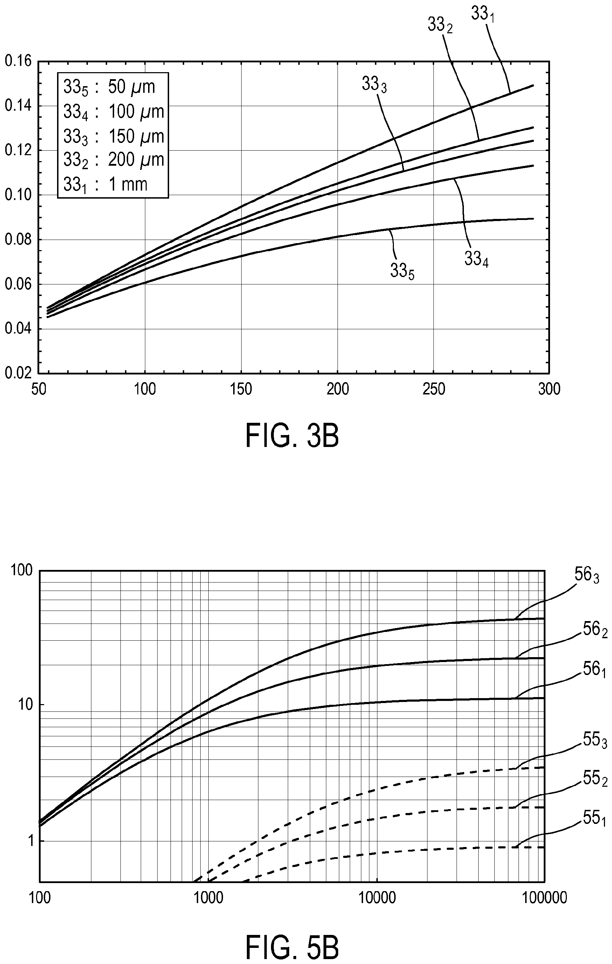

Aux figures 3A et 3B, on suppose qu'il n'y a pas de gradient de température dans la couche intermédiaire gazeuse 4 depuis l'interface avec le matériau 5 à une température de référence jusqu'à l'interface avec l'élément optique 2. La température est supposée la même partout : sur les surfaces de la cellule et au sein du gaz.

La figure 3A illustre un graphique de conductivités thermiques de la couche intermédiaire gazeuse 4, en fonction de la pression dans celle-ci, et pour différentes épaisseurs et températures de celle-ci, lorsqu'elle est formée par de l'hélium.

L'axe des abscisses correspond à une pression en Pascal, en échelle logarithmique.

L'axe des ordonnées correspond à une conductivité thermique en Watts par mètre par Kelvin, en échelle logarithmique.

Les courbes en trait continu $30_1$, $30_2$, $30_3$ représentent respectivement la conductivité thermique en fonction de la pression, dans une couche intermédiaire gazeuse 4 présentant une épaisseur de 200 $\mu$m, 150 $\mu$m et 100 $\mu$m, à 160 K

Les courbes en trait pointillé $31_1$, $31_2$, $31_3$ représentent respectivement la conductivité thermique en fonction de la pression, dans une couche intermédiaire gazeuse 4 présentant une épaisseur de 200 $\mu$m, 150 $\mu$m et 100 $\mu$m, à 300 K

On voit que le dispositif 1 selon l'invention est utilisable à toutes températures, notamment des températures « ambiantes » (autour de 300 K) aux basses températures (par exemple autour de 160 K, mais on peut aussi utiliser le dispositif 1 selon l'invention à des températures plus basses encore, par exemple 4 K).

Pour une pression allant de $10^3$ à $10^4$ Pa, et pour les températures et épaisseurs prises comme exemples, on se trouve dans le régime de diffusion transitoire sur au moins 80% de l'épaisseur de la couche intermédiaire gazeuse 4.

On voit que pour une pression allant de $10^3$ à $10^4$ Pa, la conductivité thermique de la couche intermédiaire gazeuse 4 varie fortement en fonction de la pression.

On voit que la conductivité thermique de la couche intermédiaire gazeuse 4 varie avec son épaisseur (ici entre 100 $\mu$m et 200 $\mu$m).

Il est donc possible, en modifiant la pression dans ladite couche intermédiaire gazeuse 4, d'obtenir une conductivité thermique souhaitée.

Il est donc possible, en modifiant l'épaisseur de ladite couche intermédiaire gazeuse 4, d'obtenir une conductivité thermique souhaitée.

Cette conductivité thermique est liée à une quantité de chaleur pouvant être échangée entre l'élément optique 2 et le matériau 5, par l'intermédiaire de la couche intermédiaire gazeuse 4.

Elle est donc liée à la température de l'élément optique 2 que l'on souhaite atteindre.

Chacun des paramètres du graphique de la figure 3A, (notamment l'épaisseur L de la couche intermédiaire gazeuse 4, sa pression p et sa température T) peut être exprimé en fonction de coordonnées x et y correspondant à une position sur la surface de la couche intermédiaire gazeuse 4. On peut donc prévoir une conductivité thermique différente en fonction de la position sur la couche intermédiaire gazeuse 4.

On peut ainsi s'adapter à des conditions différentes en fonction de la position sur la couche intermédiaire gazeuse 4.

En particulier, si une quantité d'énergie arrivant sur un endroit de l'élément optique 2 diffère selon la position surfacique sur l'élément optique 2, on peut ajuster la couche intermédiaire gazeuse 4 pour obtenir néanmoins une température parfaitement homogène dans tout l'élément optique.

La figure 3B illustre plus particulièrement le fait que le dispositif 1 selon l'invention est utilisable sur une gamme de températures, allant par exemple de 160 K à la température dite « ambiante » (autour de 300 K).

L'axe des abscisses correspond à une température en K (Kelvin) dans la couche intermédiaire gazeuse 4.

L'axe des ordonnées correspond à une conductivité thermique de la couche intermédiaire gazeuse 4, en Watts par mètre par Kelvin.

Les courbes $33_1$, $33_2$, $33_3$, $33_4$ et $33_5$ représentent respectivement la conductivité thermique de la couche intermédiaire gazeuse 4 en fonction de sa température, et pour épaisseur de 1000 $\mu$m, 200 $\mu$m, 150 $\mu$m, 100 $\mu$m et 50 $\mu$m, à $10^4$ Pa.

La couche intermédiaire gazeuse est formée par de l'hélium.

Pour toute la gamme de températures et d'épaisseurs représentée, et pour une pression de $10^4$ Pa, on se trouve dans le régime de diffusion transitoire sur au moins 80% de l'épaisseur de la couche intermédiaire gazeuse 4.

On voit que la conductivité thermique de la couche intermédiaire gazeuse 4 varie fortement en fonction de sa température variant par exemple entre 50 K et 300 K.

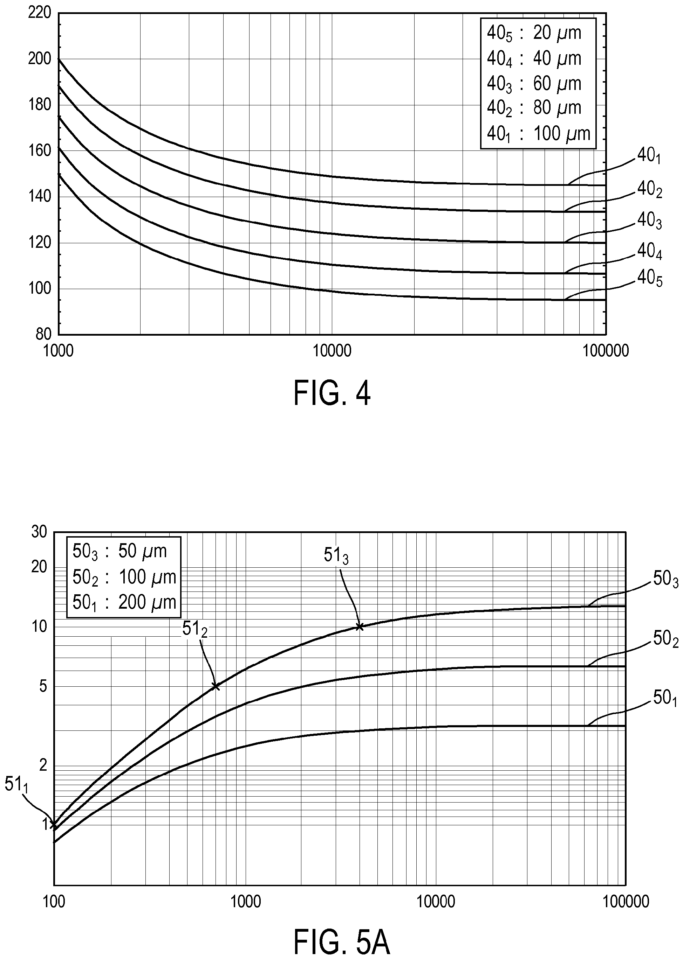

La figure 4 montre des courbes de température dans l'élément optique 2, en particulier sur la surface de contact 3 entre l'élément optique 2 et la couche intermédiaire gazeuse 4, en fonction de la pression dans la couche intermédiaire gazeuse 4, pour un dispositif 1 selon l'invention, et pour différentes épaisseurs de ladite couche 4.

Le dispositif 1 selon l'invention est celui représenté à la figure 2, le matériau 5 étant maintenu à 77 K.

Le flux thermique entre l'élément optique 2 et la couche intermédiaire gazeuse 4, est de 5 W/cm$^2$ pour tous les points des courbes.

L'axe des abscisses correspond à une pression en Pascal, en échelle logarithmique.

L'axe des ordonnées correspond à une température en Kelvin.

Les courbes $40_1$, $40_2$, $40_3$, $40_4$ et $40_5$ représentent respectivement la température sur la surface de contact 3 en fonction de la pression dans la couche intermédiaire gazeuse 4, pour une épaisseur de ladite couche 100 $\mu$m, 80 $\mu$m, 60 $\mu$m, 40 $\mu$m et 20 $\mu$m.

La couche intermédiaire gazeuse est formée par de l'hélium.

Pour une pression allant de 10$^3$ à 10$^4$ Pa, et pour les épaisseurs prises comme exemples, on se trouve dans le régime de diffusion transitoire sur au moins 80% de l'épaisseur de la couche intermédiaire gazeuse 4.

On voit que de fines épaisseurs pour la couche intermédiaire gazeuse 4 permettent d'atteindre, à pression égale dans la couche intermédiaire gazeuse 4, des températures plus faibles sur la surface de contact 3.

Par exemple, on privilégie des épaisseurs par exemple de l'ordre de la dizaine de micromètres, si l'objectif est une température cryogénique (soit inférieure à 120 K) dans l'élément optique 2.

On voit que dans le régime transitoire obtenu dans le dispositif 1 selon l'invention, on peut, pour obtenir une température voulue de la surface de contact 3, et pour une composition donnée de la couche intermédiaire gazeuse 4 et une température donnée du matériau 5 à une température de référence, fixer la pression dans la couche intermédiaire gazeuse 4 et ajuster l'épaisseur de ladite couche. On peut également fixer l'épaisseur de la couche intermédiaire gazeuse 4 et ajuster la pression dans ladite couche 4.

On voit également que pour une pression comprise entre 10$^3$ Pa et 10$^4$ Pa, on a une grande sensibilité de la température de l'élément optique 2 en fonction de la pression dans la couche intermédiaire gazeuse 4.

La figure 5A illustre un graphique de transferts thermiques entre l'élément optique 2 et le matériau 5, en passant par la couche intermédiaire gazeuse 4, en fonction de la pression dans la couche intermédiaire gazeuse 4, et pour différentes épaisseurs de ladite couche 4.

Le transfert thermique dépend notamment de la conductivité thermique de la couche intermédiaire gazeuse et de l'élément optique 2.

Le transfert thermique a été calculé dans le cas particulier du régime transitoire obtenu dans un dispositif 1 selon l'invention (voir l'article Y. Demirel and S. C. Saxena, « Heat transfert through a low-pressure gas enclosure as a thermal insulator : design condiderations », Int. Journ. of Energy Research 20, 327-338 (1996)).

Le matériau 5 à une température de référence est maintenu à 77 K.

L'élément optique 2 est un milieu à gain à 160 K.

La température de la couche intermédiaire gazeuse varie de 160 K à l'interface avec l'élément optique 2, à 77K à l'interface avec le matériau 5 à une température de référence.

L'axe des abscisses correspond à une pression en Pascal, en échelle logarithmique.

L'axe des ordonnées correspond au flux thermique entre l'élément optique 2 et le matériau 5 à une température de référence, en passant par la couche intermédiaire gazeuse 4, en W/cm$^2$ et en échelle logarithmique.

Les courbes $50_1$, $50_2$ et $50_3$ représentent respectivement ledit flux thermique en fonction de la pression dans la couche intermédiaire gazeuse 4, pour une épaisseur de ladite couche 200 $\mu$m, 100 $\mu$m et 50 $\mu$m.

La couche intermédiaire gazeuse est formée par de l'hélium.

Pour une pression allant de 10$^2$ à 10$^4$ Pa, et pour les épaisseurs prises comme exemples, on se trouve dans le régime de diffusion transitoire sur au moins 80% de l'épaisseur de la couche intermédiaire gazeuse 4.

On voit que dans le régime transitoire obtenu dans le dispositif 1 selon l'invention, pour obtenir un transfert thermique donné entre l'élément optique 2 et le matériau 5 à une température de référence, en passant par la couche intermédiaire gazeuse 4 (pour une composition gazeuse donnée) :

- on peut fixer la pression et la température dans la couche intermédiaire gazeuse 4 (notamment la température à l'interface avec le matériau 5 à une température de référence) et ajuster l'épaisseur de ladite couche ;
- on peut fixer l'épaisseur et la température de la couche intermédiaire gazeuse 4 (notamment la température à l'interface avec le matériau 5 à une température de référence) et ajuster la pression dans ladite couche 4.

Pour une température désirée dans l'élément optique 2, on gère le transfert thermique entre l'élément optique 2 et le matériau 5 à une température de référence, en passant par la couche intermédiaire gazeuse 4.

Plus l'on souhaite un refroidissement ou chauffage important de l'élément optique 2, plus le transfert thermique doit être élevé.

La figure 5B compare des transferts thermiques entre l'élément optique 2 et le matériau 5 à une température de référence, en passant par la couche intermédiaire gazeuse 4, en fonction de la pression dans la couche intermédiaire gazeuse 4 et pour différentes épaisseurs de ladite couche 4.

L'élément optique 2 est un milieu à gain à 293 K, soit la température ambiante.

Les courbes $55_1$, $55_2$ et $55_3$ représentent respectivement le flux thermique entre l'élément optique 2 et le matériau 5 à une température de référence, en passant par la couche intermédiaire gazeuse 4, en fonction de la pression dans la couche intermédiaire gazeuse 4, pour une épaisseur de ladite couche 200 $\mu$m, 100 $\mu$m et 50 $\mu$m, et pour une température du matériau 5 à une température de référence de 280 K, soit la température d'une eau froide.

Les courbes $56_1$, $56_2$ et $56_3$ représentent respectivement le flux thermique entre l'élément optique 2 et le matériau 5 à une température de référence, en passant par la couche intermédiaire gazeuse 4, en fonction de la pression dans la couche intermédiaire gazeuse 4, pour une épaisseur de ladite couche 200 $\mu$m, 100 $\mu$m et 50 $\mu$m, et pour une température du matériau 5 à une température de référence de 77 K, soit la température de l'azote liquide.

La couche intermédiaire gazeuse est formée par de l'hélium.

Pour une pression allant environ de $10^2$ à $10^4$ Pa, respectivement $10^3$ à $10^5$ Pa (de $10^2$ à $10^3$ Pa, les courbes correspondantes ne sont pas visibles sur la figures), et pour les épaisseurs prises comme exemples, on se trouve dans le régime de diffusion transitoire sur au moins 80% de l'épaisseur de la couche intermédiaire gazeuse 4.

On montre que même si le dispositif 1 selon l'invention est efficace à la température ambiante comme aux basses températures, le transfert thermique maximum atteignable est plus élevé dans le cas des basses températures qui permettent donc un refroidissement plus efficace.

Les propriétés d'ajustabilité, qui sont illustrées notamment en référence aux figures 3A à 5B, présentent un avantage, notamment lorsqu'on souhaite modifier une cadence d'utilisation de l'élément optique 2.

L'élément optique 2 est par exemple un milieu à gain d'un laser haute puissance (délivrant par exemple des impulsions de plusieurs centaines de Joules, jusqu'à plusieurs kiloJoules).

Le dispositif 1 selon l'invention apporte un refroidissement particulièrement efficace, permettant d'augmenter la cadence de tels tirs lasers, en passant par exemple de 1 Hz à 10 Hz (les durées d'impulsions sont par exemple de l'ordre de la picoseconde ou la nanoseconde ou la femtoseconde).

En outre, les propriétés d'adaptabilité du dispositif 1 selon l'invention permettent de modifier la cadence des tirs lasers, en cours d'utilisation, et tout en maintenant une température constante du milieu à gain 2.

D'après la courbe $50_3$ à la figure 5A, si une pression de 100 Pa est requise pour une cadence de tir laser de 1 Hz (point $51_1$), alors pour des impulsions identiques, on doit avoir, pour maintenir constante la température du milieu à gain 2 :

- une pression de $7.10^2$ Pa pour une cadence de tir laser de 5 Hz (point $51_2$),
- une pression de $4.10^3$ Pa pour une cadence de tir laser de 10 Hz (point $51_3$).

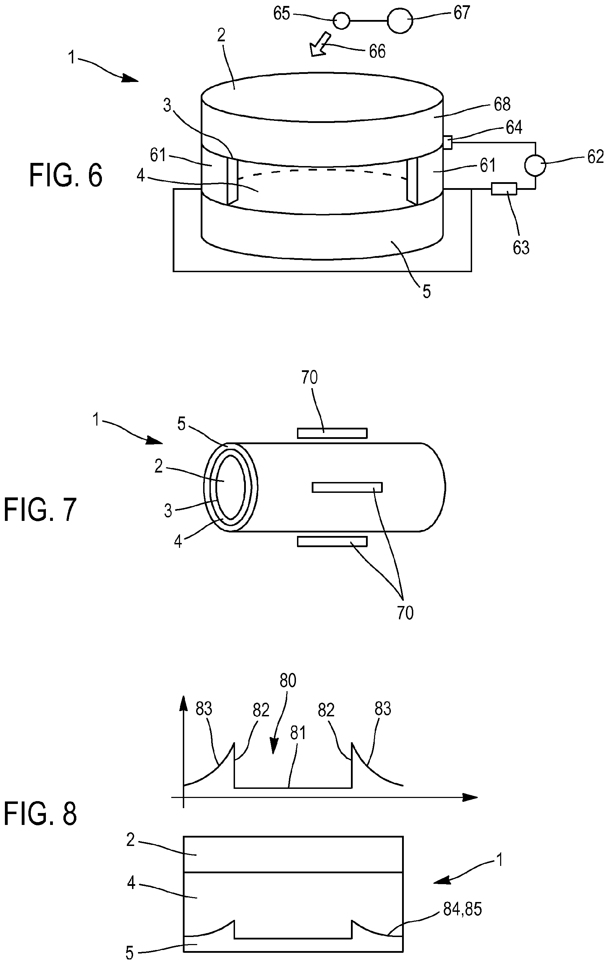

La figure 6 illustre un deuxième mode de réalisation de dispositif 1 selon l'invention.

L'élément optique 2 est un milieu à gain.

Il s'agit par exemple de YAG dopé Ytterbium à une concentration de 0,15 at.% (pourcentage atomique), pour une émission dans l'infrarouge proche.

Ses dimensions sont par exemple 2,6 cm d'épaisseur pour une surface de 12,11x11,44 cm$^2$.

La couche intermédiaire gazeuse 4 est un volume fermé d'hélium.

Le matériau 5 à une température de référence est une plaque de cuivre maintenue à 77 K.

Le milieu à gain 2 est ainsi maintenu à 160 K.

Les conditions de pression et d'épaisseur sont réunies de sorte le rapport du libre parcours moyen des molécules de gaz dans au moins 95% de l'épaisseur de la couche intermédiaire gazeuse 4, soit compris entre 0,1 et 10.

La surface de contact 3 comprend un traitement hautement réfléchissant (99,9%) à une longueur d'onde d'émission du milieu à gain 2, et déposé sur celui-ci.

L'ensemble forme un laser à disque (fonctionnement en réflexion), pompé par au moins une diode de pompe 65 située du côté du milieu à gain 2 opposé à la surface de contact 3 (on parle alors de surface active).

La diode de pompe 65 émet un faisceau de pompe 66 super-gaussien (une super-gaussienne peut être définie par une fonction du type $f(x) = Ae^{-\left(\frac{x-b}{a}\right)^{n>2}}$ ), d'une durée de 0,7 ms et d'éclairement égal à 6 kW/cm$^2$ sur une surface de 11,11x10,44 cm$^2$.

Environ 4900 W du faisceau de pompe 66 sont absorbés par le milieu à gain 2, dont 10% sont convertis en chaleur.

La couche intermédiaire gazeuse est donc paramétrée de façon à pouvoir évacuer 490 W hors du milieu à gain 2.

Le faisceau laser est émis du côté opposé à la surface de contact 3 comprenant le traitement hautement réfléchissant.

Un avantage de ce mode de réalisation est que ni le faisceau laser émis, ni le faisceau de pompe 66 ne traverse la couche intermédiaire gazeuse 4. La couche intermédiaire gazeuse 4 ne produit donc aucune perturbation optique.

Un autre avantage de ce mode de réalisation est que le traitement hautement réfléchissant n'est pas en contact avec un solide ou un liquide tel qu'une colle qui serait susceptible de chauffer en absorbant le faisceau à la longueur d'onde d'émission (par exemple 0,1% d'absorption). Le traitement réfléchissant est ainsi préservé de toute dégradation en particulier par des phénomènes de surchauffe additionnels.

Le dispositif 1 selon l'invention comprend des moyens 67 de modification de la cadence d'émission du faisceau de pompe 66.

L'épaisseur de la couche intermédiaire gazeuse 4 peut être modifiée grâce à des cales piézo-électriques 61 dont on peut modifier l'épaisseur grâce à l'alimentation électrique 63.

Le laser à disque peut donc être utilisé à différentes cadences, différentes puissances de pompe, etc, tout en maintenant facilement une température stable du milieu à gain 2.

Le laser à disque peut être utilisé pour produire des impulsions haute énergie (par exemple plusieurs centaines de Joules voir plusieurs kiloJoules par impulsion), grâce à un refroidissement efficace grâce au dispositif 1 selon l'invention.

On peut ainsi s'affranchir ou limiter des inconvénients tels que les distorsions optiques :

- dues à des gradients thermiques dans le milieu à gain 2 (notamment la biréfringence thermique dans le milieu à gain 2, ou une lentille thermique dans le milieu à gain 2) ;
- dues à la contrainte mécanique générée par la distribution de chaleur dans le milieu à gain 2.

On a également représenté à la figure 6 des moyens de contre-réaction 62. Les moyens de contre-réaction 62 agissent sur l'alimentation électrique 63 en fonction d'une mesure directe ou indirecte de la température sur la surface de contact 3 (côté élément optique 2) mesurée par un capteur 64.

A la figure 6, le capteur 64 effectue une mesure directe de la température de l'élément optique 2. Cependant, on peut préférer des mesures indirectes, notamment en utilisant des informations de phase d'un faisceau lumineux passant par l'élément optique 2.

Les moyens de contre-réaction 62 permettent par exemple de maintenir constante de façon automatique et en temps réel la température de la surface de contact 3 (côté élément optique 2) et plus généralement de l'élément optique 2 (formé ici par un milieu à gain). On maintient ainsi les conditions de fonctionnement du milieu à gain 2 (même contrainte mécanique, même lentille thermique, même biréfringence, etc). On garde ainsi la même qualité et la même énergie de faisceau laser d'émission.

Selon une variante non représentée, les moyens de contre-réaction agissent sur une pompe à vide pour modifier la pression dans la couche intermédiaire gazeuse en fonction de la température sur la surface de contact 3.

Selon une variante non représentée, les moyens de contre-réaction agissent sur au moins une résistance chauffante pour modifier la température du matériau 5 à une température de référence en fonction de la température sur la surface de contact 3.

Selon d'autres variantes, le dispositif 1 selon l'invention est mis en oeuvre dans une fibre optique, ou dans tout type de dispositif de transport, d'amplificateur optique ou d'oscillateur optique.

On a considéré ici que la température en un point de la surface de contact 3 correspond à la température dans tout l'élément optique 2.

On verra dans la suite que l'on peut considérer la température en différents points de l'élément optique (par exemple via les mesures de phases précitées), notamment en vue d'homogénéifier la température en la rendant égale en tous points de l'élément optique 2.

La figure 7 illustre un troisième mode de réalisation de dispositif 1 selon l'invention.

Selon ce troisième mode de réalisation, le dispositif 1 selon l'invention est mis en oeuvre dans système de transport cylindrique (fibre optique) ou un amplificateur cylindrique (barreau ou fibre optique).

En partant du coeur de la fibre et en se déplaçant vers l'extérieur, on trouve successivement :

- un milieu à gain 2 ;
- une surface de contact 3 ;
- une couche intermédiaire gazeuse 4 (par exemple de l'hélium) ; et
- un matériau 5 à une température de référence.

Les conditions de température, de pression et d'épaisseur de la couche intermédiaire gazeuse 4 sont réunies de sorte le rapport du libre parcours moyen des molécules de gaz dans au moins 95% de l'épaisseur de la couche intermédiaire gazeuse 4, soit compris entre 0,1 et 10.

**EP 2 700 131 B1**

Le milieu à gain 2 est pompé optiquement par exemple par des diodes de pompe (ou des lampes flashes, ou un autre laser) 70 (trois de ces sources sont représentées à la figure 7, une quatrième étant située derrière le dispositif 1 selon l'invention).

Le milieu à gain 2 est donc chauffé de façon inhomogène par la source de pompe, sur la surface de contact 3.

Pour remédier à ce chauffage inhomogène et obtenir quand même une température homogène sur toute la surface de contact 3, on utilise le dispositif 1 selon l'invention, en faisant varier localement en fonction de la répartition de chaleur due aux diodes de pompe, la température du matériau 5 à une température de référence.

On pourrait aussi envisager de faire varier localement la pression dans la couche intermédiaire gazeuse 4 et/ou l'épaisseur de la couche intermédiaire gazeuse 4.

On peut par exemple modifier localement la température du matériau 5 à une température de référence en la reliant à des résistances chauffantes non représentées réparties autour du matériau 5 à une température de référence.

Une autre source d'inhomogénéité dans la distribution spatiale de la chaleur à évacuer hors d'un élément optique 2 pour maintenir celui-ci à une température stable et homogène peut être la présence d'un matériau d'absorption autour d'un milieu à gain 2.

Un tel matériau est appelé « cladding », et permet d'absorber l'émission spontanée amplifiée (ASE, pour l'anglais « amplified spontaneous émission ») dans le milieu à gain.

Un tel matériau entoure latéralement le milieu à gain 2 dans un laser à disque tel que représenté à la figure 6 (la surface latérale du milieu à gain 2 est référencée 68).

Les courbes de la figure 8 sont présentées pour leurs tendances, c'est pourquoi les échelles ne sont pas précisées.

A la figure 8, on a représenté en haut la courbe 80 de la distribution de chaleur en fonction de la position selon un axe passant par le centre d'une surface de contact étendue.

La surface de contact étendue correspond à la surface de contact entre la couche intermédiaire gazeuse 4 d'une part, et d'autre part l'ensemble formé par le milieu à gain 2 et le matériau d'absorption.

La courbe 80 présente un palier 81 qui correspond à la surface de contact entre la couche intermédiaire gazeuse 4 et le milieu à gain 2.

La courbe 80 présente deux décrochements 82 qui correspondent à l'interface entre le milieu à gain 2 et le matériau d'absorption.

La courbe 80 présente deux portions de courbe 83 qui correspondent à la surface de contact entre la couche intermédiaire gazeuse 4 et le milieu d'absorption (cladding).

A la figure 8, on a représenté en bas, selon ce même axe des abscisses, une vue en coupe du dispositif 1 selon l'invention permettant d'obtenir une température égale en tout point de la surface de contact étendue.

Pour cela, on utilise les propriétés de variation de la conductivité thermique de la couche intermédiaire gazeuse 4 en fonction de l'épaisseur de celle-ci.

On prévoit donc un profil de la surface d'interface 84 entre la couche intermédiaire gazeuse 4 et le matériau 5 à une température de référence, proportionnel au profil de distribution de la charge thermique sur la surface de contact étendue. En effet, la figure 5A montre bien qu'à pression constante, il faudra une épaisseur de couche gazeuse plus faible pour évacuer plus de chaleur.

La surface d'interface 84 entre la couche intermédiaire gazeuse 4 et le matériau 5 à une température de référence peut être déformable et pilotée de façon à former avec des moyens de pilotage non représentés un moyen de réglage 85 pour régler localement l'épaisseur de la couche intermédiaire gazeuse.

On peut également prévoir d'adapter de la même façon la surface d'interface 84 pour compenser la forme gaussienne ou super-gaussienne du faisceau de pompe incident sur un élément optique 2.

Bien sûr, l'invention n'est pas limitée aux exemples qui viennent d'être décrits et de nombreux aménagements peuvent être apportés à ces exemples sans sortir du cadre de l'invention.

En particulier, on peut appliquer le principe décrit à tout dispositif, notamment tout dispositif laser, et pour toutes gammes d'énergie, peu importe la forme (plaque, barreau, en mosaïque etc) du milieu à gain.

On peut appliquer le principe décrit à d'autres types de milieux optiques que des milieux à gain, des lors que l'on souhaite pouvoir piloter leur température.

Les éléments optiques peuvent être utilisés à une cadence donnée, ou en continu.

**Revendications**

1.  Dispositif (1) pour la gestion thermique d'un élément optique (2), comprenant :

    - l'élément optique (2) ;
    - un matériau (5) à une température de référence ; et

**14**

- une couche intermédiaire gazeuse (4) située directement entre le matériau (5) à une température de référence et l'élément optique (2), l'épaisseur de la couche intermédiaire gazeuse étant comprise entre 10 μm et 5 mm,
- **caractérisé en ce que** ladite couche intermédiaire gazeuse (4) se trouve sur au moins une partie de son épaisseur dans le régime de diffusion dit « transitoire » défini par une épaisseur de la couche intermédiaire gazeuse (4) telle que le rapport du libre parcours moyen des molécules de gaz dans la couche intermédiaire gazeuse (4) sur ladite épaisseur soit compris entre 0,1 et 10.

2. Dispositif (1) selon la revendication 1, **caractérisé en ce que** l'élément optique (2) comprend au moins un élément parmi :

- un milieu à gain ;
- un milieu non linéaire de conversion de fréquence ;
- un milieu multi réfringent ;
- un milieu agissant sur la polarisation ;
- un élément dioptrique ;
- un élément catoptrique ; ou
- un milieu semi-conducteur.

3. Dispositif (1) selon la revendication 1 ou 2, **caractérisé en ce que** la couche intermédiaire gazeuse (4) est confinée dans un volume fermé (25).

4. Dispositif (1) selon l'une quelconque des revendications 1 à 3, **caractérisé en ce que** le matériau (5) à une température de référence présente une température inférieure à 200 K, et **en ce que** l'élément optique (2) est un milieu à gain solide refroidi par le matériau (5) à une température de référence.

5. Dispositif (1) selon l'une quelconque des revendications 1 à 4, **caractérisé en ce que** la couche intermédiaire gazeuse (4) est constituée à au moins 90% par de l'Hélium.

6. Dispositif (1) selon l'une quelconque des revendications 1 à 5, **caractérisé en ce qu'**il comprend au moins un moyen de réglage (61) parmi :

- un moyen de réglage de l'épaisseur de la couche intermédiaire gazeuse (4) ;
- un moyen de réglage de la pression dans la couche intermédiaire gazeuse (4) ;
- un moyen de réglage de la température du matériau (5) à une température de référence.

7. Dispositif (1) selon la revendication 6, **caractérisé en ce qu'**il comprend au moins un moyen de réglage (85) pour régler localement l'épaisseur de la couche intermédiaire gazeuse, la pression dans la couche intermédiaire gazeuse (4) et/ou la température du matériau (5) à une température de référence.

8. Dispositif selon les revendications 6 ou 7, **caractérisé en ce qu'**il comprend des moyens de contre-réaction (62) agissant sur au moins un moyen de réglage (61, 85) en fonction d'au moins une mesure représentative de la température de l'élément optique (2).

9. Dispositif selon l'une quelconque des revendications 6 à 8, **caractérisé en ce qu'**il comprend des moyens (67) de modification d'une cadence d'utilisation de l'élément optique (2).

10. Dispositif (1) selon l'une quelconque des revendications 1 à 9, **caractérisé en ce que** l'élément optique (2) présente une face (3) recouverte d'un traitement hautement réfléchissant et **en ce que** la couche intermédiaire gazeuse (4) est en contact direct avec ladite face (3).

11. Procédé de gestion thermique, pour la gestion thermique d'un élément optique (2), mis en oeuvre dans un dispositif (1) selon l'une quelconque des revendications précédentes, dans lequel on utilise une couche intermédiaire gazeuse (4) située directement entre un matériau (5) à une température de référence et l'élément optique (2), l'épaisseur de la couche intermédiaire gazeuse étant comprise entre 10 μm et 5 mm, **caractérisé en ce que** ladite couche intermédiaire gazeuse (4) se trouve sur au moins une partie de son épaisseur dans le régime de diffusion dit « transitoire » défini par une épaisseur de la couche intermédiaire gazeuse (4) telle que le rapport du libre parcours moyen des molécules de gaz dans la couche intermédiaire gazeuse (4) sur ladite épaisseur soit compris entre 0,1 et 10.

**12.** Procédé de gestion thermique selon la revendication 11, **caractérisé en ce qu'**on règle au moins un paramètre parmi :

- la pression dans la couche intermédiaire gazeuse (4) ;
- l'épaisseur de la couche intermédiaire gazeuse (4) ;
- la température du matériau (5) à une température de référence ;

de façon à asservir la température de l'élément optique (2).

**13.** Procédé de gestion thermique selon la revendication 11 ou 12, **caractérisé en ce qu'**on règle au moins un paramètre parmi :

- la pression dans la couche intermédiaire gazeuse (4) ;
- l'épaisseur de la couche intermédiaire gazeuse (4) ;
- la température du matériau (5) à une température de référence ;

en fonction d'une cadence d'utilisation de l'élément optique (2).

**14.** Procédé de gestion thermique selon l'une quelconque des revendications 11 à 13, **caractérisé en ce qu'**on l'utilise pour mettre en oeuvre un transfert thermique compris entre 1 mW/cm$^2$ et 50 W/cm$^2$, entre l'élément optique (2) et le matériau à une température de référence (5), par l'intermédiaire de la couche intermédiaire gazeuse (4).


**Patentansprüche**

**1.** Vorrichtung (1) zur Wärmeverwaltung eines optischen Elements (2), umfassend:

- das optische Element (2);
- ein Material (5) mit einer Referenztemperatur; und
- eine gasförmige Zwischenschicht (4), die sich direkt zwischen dem Material (5) mit einer Referenztemperatur und dem optischen Element (2) befindet, wobei die Dicke der gasförmigen Zwischenschicht zwischen 10 $\mu$m und 5 mm beträgt,

**dadurch gekennzeichnet, dass** sich die gasförmige Zwischenschicht (4) auf mindestens einem Teil ihrer Dicke in dem so genannten "transitorischen" Diffusionssystem befindet, das durch eine Dicke der gasförmigen Zwischenschicht (4) definiert ist, so dass das Verhältnis der mittleren freien Weglänge der Gasmoleküle in der gasförmigen Zwischenschicht (4) zur Dicke zwischen 0,1 und 10 beträgt.

**2.** Vorrichtung (1) nach Anspruch 1, **dadurch gekennzeichnet, dass** das optische Element (2) mindestens ein Element unter den folgenden umfasst:

- Verstärkungsmedium;
- ein nicht lineares Frequenzumwandlungsmedium;
- ein multirefringentes Medium;
- ein auf die Polarisation einwirkendes Medium;
- ein dioptrisches Element;
- ein katoptrisches Element; oder
- ein Halbleitermedium.

**3.** Vorrichtung (1) nach Anspruch 1 oder 2, **dadurch gekennzeichnet, dass** die gasförmige Zwischenschicht (4) in einem geschlossenen Volumen (25) eingegrenzt ist.

**4.** Vorrichtung (1) nach einem der Ansprüche 1 bis 3, **dadurch gekennzeichnet, dass** das Material (5) mit einer Referenztemperatur eine Temperatur unter 200 K aufweist, und dass das optische Element (2) ein festes Verstärkungsmedium ist, das durch das Material (5) mit einer Referenztemperatur gekühlt wird.

**5.** Vorrichtung (1) nach einem der Ansprüche 1 bis 4, **dadurch gekennzeichnet, dass** die gasförmige Zwischenschicht (4) zu mindestens 90% aus Helium gebildet ist.

**6.** Vorrichtung (1) nach einem der Ansprüche 1 bis 5, **dadurch gekennzeichnet, dass** sie mindestens ein Einstellmittel (61) unter folgenden umfasst:

- ein Mittel zur Einstellung der Dicke der gasförmigen Zwischenschicht (4);
- ein Mittel zur Einstellung des Drucks in der gasförmigen Zwischenschicht (4);
- ein Mittel zur Einstellung der Temperatur des Materials (5) mit einer Referenztemperatur.

**7.** Vorrichtung (1) nach Anspruch 6, **dadurch gekennzeichnet, dass** sie mindestens ein Einstellmittel (85) umfasst, um lokal die Dicke der gasförmigen Zwischenschicht, den Druck in der gasförmigen Zwischenschicht (4) und/oder die Temperatur des Materials (5) mit einer Referenztemperatur einzustellen.

**8.** Vorrichtung nach den Ansprüchen 6 oder 7, **dadurch gekennzeichnet, dass** sie Gegenreaktionsmittel (62) umfasst, die auf mindestens ein Einstellmittel (61, 85) in Abhängigkeit von mindestens einer für die Temperatur des optischen Elements (2) repräsentativen Messung einwirken.

**9.** Vorrichtung nach einem der Ansprüche 6 bis 8, **dadurch gekennzeichnet, dass** sie Mittel (67) zur Veränderung einer Verwendungshäufigkeit des optischen Elements (2) umfasst.

**10.** Vorrichtung (1) nach einem der Ansprüche 1 bis 9, **dadurch gekennzeichnet, dass** das optische Element (2) eine Seite (3) aufweist, die mit einer hoch reflektierenden Behandlung versehen ist, und dass die gasförmige Zwischenschicht (4) mit der Seite (3) in direktem Kontakt ist.

**11.** Verfahren zur Wärmeverwaltung zur Wärmeverwaltung eines optischen Elements (2), das in einer Vorrichtung (1) nach einem der vorhergehenden Ansprüche eingesetzt wird, bei dem eine gasförmige Zwischenschicht (4), die sich direkt zwischen einem Material (5) mit einer Referenztemperatur und dem optischen Element (2) befindet, verwendet wird, wobei die Dicke der gasförmigen Zwischenschicht zwischen 10 $\mu$m und 5 mm beträgt, **dadurch gekennzeichnet, dass** sich die gasförmige Zwischenschicht (4) auf mindestens einem Teil ihrer Dicke in dem so genannten "transitorischen" Diffusionssystem befindet, das durch eine Dicke der gasförmigen Zwischenschicht (4) definiert ist, so dass das Verhältnis der mittleren freien Weglänge der Gasmoleküle in der gasförmigen Zwischenschicht (4) zur Dicke zwischen 0,1 und 10 beträgt.

**12.** Verfahren zur Wärmeverwaltung nach Anspruch 11, **dadurch gekennzeichnet, dass** mindestens ein Parameter unter den folgenden eingestellt wird:

- der Druck in der gasförmigen Zwischenschicht (4) ;
- die Dicke der gasförmigen Zwischenschicht (4);
- die Temperatur des Materials (5) mit einer Referenztemperatur;

um die Temperatur des optischen Elements (2) zu steuern.

**13.** Verfahren zur Wärmeverwaltung nach Anspruch 11 oder 12, **dadurch gekennzeichnet, dass** mindestens ein Parameter unter den folgenden eingestellt wird:

- der Druck in der gasförmigen Zwischenschicht (4) ;
- die Dicke der gasförmigen Zwischenschicht (4);
- die Temperatur des Materials (5) mit einer Referenztemperatur;

in Abhängigkeit von einer Verwendungshäufigkeit des optischen Elements (2).

**14.** Verfahren zur Wärmeverwaltung nach einem der Ansprüche 11 bis 13, **dadurch gekennzeichnet, dass** es für den Einsatz einer Wärmeübertragung zwischen 1 mW/cm$^2$ und 50 W/cm$^2$ zwischen dem optischen Element (2) und dem Material mit einer Referenztemperatur (5) mit Hilfe der gasförmigen Zwischenschicht (4) verwendet wird.

**Claims**

**1.** Device (1) for thermal management of an optical element (2), comprising:

- the optical element (2);
- a material (5) at a reference temperature; and
- a gaseous intermediate layer (4) located directly between the material (5) at a reference temperature and the optical element (2), the thickness of the gaseous intermediate layer being comprised between 10 $\mu$m and 5 mm,

**characterized in that** at least some of the thickness of said gaseous intermediate layer (4) is in what is called the "transitional" diffusion regime, defined by a thickness of the gaseous intermediate layer (4) such that the ratio of the mean free path of the gas molecules in the gaseous intermediate layer (4) to said thickness is comprised between 0.1 and 10.

2. Device (1) according to Claim 1, **characterized in that** the optical element (2) comprises at least one element from:

- a gain medium;
- a nonlinear, frequency-conversion medium;
- a multi-refringent medium;
- a medium acting on polarisation;
- a dioptric element;
- a catoptric element; or
- a semiconductor medium.

3. Device (1) according to Claim 1 or 2, **characterized in that** the gaseous intermediate layer (4) is confined in a closed volume (25).

4. Device (1) according to any one of Claims 1 to 3, **characterized in that** the material (5) at a reference temperature has a temperature below 200 K, and **in that** the optical element (2) is a solid gain medium cooled by the material (5) at a reference temperature.

5. Device (1) according to any one of Claims 1 to 4, **characterized in that** at least 90% of the gaseous intermediate layer (4) consists of helium.

6. Device (1) according to any one of Claims 1 to 5, **characterized in that** it comprises at least one regulating means (61) among:

- a means for regulating the thickness of the gaseous intermediate layer (4);
- a means for regulating the pressure in the gaseous intermediate layer (4);
- a means for regulating the temperature of the material (5) to a reference temperature.

7. Device (1) according to Claim 6, **characterized in that** it comprises at least one regulating means (85) for locally regulating the thickness of the gaseous intermediate layer, the pressure in the gaseous intermediate layer (4) and/or the temperature of the material (5) to a reference temperature.

8. Device according to either of Claims 6 and 7, **characterized in that** it comprises feedback means (62) acting on at least one regulating means (61, 85) depending on at least one measurement representative of the temperature of the optical element (2).

9. Device according to any one of Claims 6 to 8, **characterized in that** it comprises means (67) for modifying a rate of use of the optical element (2).

10. Device (1) according to any one of Claims 1 to 9, **characterized in that** the optical element (2) has a face (3) covered with a highly reflective treatment and **in that** the gaseous intermediate layer (4) makes direct contact with said face (3).

11. Thermal management method for the thermal management of an optical element (2), implemented in a device (1) according to any one of the preceding claims, in which use is made of a gaseous intermediate layer (4) located directly between a material (5) at a reference temperature and the optical element (2), the thickness of the gaseous intermediate layer being comprised between 10 $\mu$m and 5 mm,
**characterized in that**
at least some of the thickness of said gaseous intermediate layer (4) is in what is called the "transitional" diffusion regime, defined by a thickness of the gaseous intermediate layer (4) such that the ratio of the mean free path of the gas molecules in the gaseous intermediate layer (4) to said thickness is comprised between 0.1 and 10.

12. Thermal management method according to Claim 11, **characterized in that** at least one parameter among:

- the pressure in the gaseous intermediate layer (4);
- the thickness of the gaseous intermediate layer (4); and
- the temperature of the material (5) at a reference temperature;

is regulated so as to automatically control the temperature of the optical element (2).

13. Thermal management method according to Claim 11 or 12, **characterized in that** at least one parameter among:

- the pressure in the gaseous intermediate layer (4);
- the thickness of the gaseous intermediate layer (4); and
- the temperature of the material (5) at a reference temperature;

is regulated depending on a rate of use of the optical element (2).

14. Thermal management method according to any one of Claims 11 to 13, **characterized in that** it is used to achieve, via the gaseous intermediate layer (4), between 1 mW/cm$^2$ and 50 W/cm$^2$ of heat transfer between the optical element (2) and the material (5) at a reference temperature.

FIG. 1

FIG. 2

FIG. 3A

| | |
|---|---|
| $30_3$ : | 100 $\mu m$ - 160K |
| $30_2$ : | 150 $\mu m$ - 160K |
| $30_1$ : | 200 $\mu m$ - 160K |
| $31_3$ : | 100 $\mu m$ - 300K |
| $31_2$ : | 150 $\mu m$ - 300K |
| $31_1$ : | 200 $\mu m$ - 300K |

FIG. 3B

FIG. 5B

FIG. 4

FIG. 5A

FIG. 6

FIG. 7

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0567287 A1
- US 5546416 A
- US 3679999 A

**Littérature non-brevet citée dans la description**

- **Y. DEMIREL ; S. C. SAXENA.** Heat transfert through a low-pressure gas enclosure as a thermal insulator : design condiderations. *Int. Journ. of Energy Research,* 1996, vol. 20, 327-338